# EUROPEAN PATENT SPECIFICATION

(11) **EP 1 856 746 B1**
(45) Date of publication and mention of the grant of the patent: **01.10.2008**
(21) Application number: 06715481.5
(22) Date of filing: 03.03.2006
(51) Int. Cl.: H01L 35/22, C01G 17/00, C01F 11/00

(54) **THERMOELECTRIC MATERIAL**
THERMOELEKTRISCHES MATERIAL
MATERIAU THERMOELECTRIQUE

(30) Priority: 09.03.2005 JP 2005065467
(43) Date of publication of application: 21.11.2007
(73) Proprietor: TOYOTA JIDOSHA KABUSHIKI KAISHA, Toyota-shi, Aichi 471-8571 (JP)
(72) Inventor: KITA, Takuji, Toyota-shi, Aichi, 4718571 (JP)
(74) Representative: Duckworth, Timothy John
(86) International application number: PCT/JP2006/304660
(87) International publication number: WO 2006/095839

(56) References cited:
- BRYAN J DANIEL ET AL: "Nonstoichiometry and chemical purity effects in thermoelectric Ba8Ga16Ge30 clathrate" JOURNAL OF APPLIED PHYSICS, AMERICAN INSTITUTE OF PHYSICS. NEW YORK, US, vol. 92, no. 12, 15 December 2002 (2002-12-15), pages 7281-7290, XP012056780 ISSN: 0021-8979
- CARRILLO-CABRERA W ET AL: "Crystal structure of Ba8Ga4.44Ge39.14-2.42, Ba8Ga8.62Ge36-1.38, and Ba8Ga12.35Ge33.27-0.38, three clathrate-I variants" ZEITSCHRIFT FUR KRISTALLOGRAPHIE - NEW CRYSTAL STRUCTURES OLDENBOURG GERMANY, vol. 217, no. 2, 2002, pages 183-185, XP002388985 ISSN: 1433-7266
- ANNO H ET AL: "Thermoelectric properties of Ba8GaxGe46-x clathrate compounds" THERMOELECTRICS, 2002. PROCEEDINGS ICT '02. TWENTY-FIRST INTERNATIONAL CONFERENCE ON AUG. 25-29, 2002, PISCATAWAY, NJ, USA,IEEE, 25 August 2002 (2002-08-25), pages 77-80, XP010637435 ISBN: 0-7803-7683-8 cited in the application
- JIANJUN DONG ET AL: "Chemical trends of the rattling phonon modes in alloyed germanium clathrates" JOURNAL OF APPLIED PHYSICS AIP USA, vol. 87, no. 11, 1 June 2000 (2000-06-01), pages 7726-7734, XP002388986 ISSN: 0021-8979
- JUNG-HWAN KIM ET AL: "High thermoelectric performance of type-III clathrate compounds of the Ba-Ge-Ga system" ACTA MATERIALIA ELSEVIER UK, vol. 54, no. 8, May 2006 (2006-05), pages 2057-2062, XP002388987 ISSN: 1359-6454
- KUZNETSOV V L ET AL: "Preparation and thermoelectric properties of A8IIB16IIIB30IV clathrate compounds" JOURNAL OF APPLIED PHYSICS, AMERICAN INSTITUTE OF PHYSICS. NEW YORK, US, vol. 87, no. 11, 1 June 2000 (2000-06-01), pages 7871-7875, XP012049172 ISSN: 0021-8979
- BERTINI L ET AL: "Thermoelectric performance of large single crystal clathrate Ba8Ga16Ge/sub 30" THERMOELECTRICS, 2003 TWENTY-SECOND INTERNATIONAL CONFERENCE ON - ICT LA GRANDE MOTTE, FRANCE AUG. 17-21, 2003, PISCATAWAY, NJ, USA,IEEE, 17 August 2003 (2003-08-17), pages 127-130, XP010697200 ISBN: 0-7803-8301-X

## Description

### TECHNICAL FIELD

The present invention relates to a thermoelectric material comprised of a clathrate compound.

### BACKGROUND ART

For a long time now, thermoelectric conversion devices (thermoelectric devices) utilizing the Seebeck effect to convert heat to electricity have been known. These have the great advantage of not requiring any drive units and being small in size and light in weight. However, they have had the defects of being lower in energy conversion efficiency compared with solar cells, fuel cells, and other conversion systems.

For commercial application, an energy conversion efficiency of at least 10% (performance index ZT of 1 or more) is required.

The thermoelectric material forming a thermoelectric device particularly requires the properties of a large thermo-electromotive force and electric conductivity and a small heat conductivity. As materials provided with these properties and having a large performance index, clathrate compounds are being looked at. As typical clathrate thermoelectric materials, for example H. Anno et al., Proc. of 21st Int. Conf. on Thermoelectrics, (2002), 78 proposes ones have compositions expressed by the general formula Ba₈GaₓGe₍₄₆₋ₓ₎, in particular ones exhibiting the highest performance index ZT at X=15 or X=18. These compounds are structured by a host lattice comprised of Ga and Ge in which Ba is incorporated as guest atoms. The bounds between the host lattice atoms and the guest atoms are loose, so locally thermal vibration occurs and as an effect phonons are disturbed in a rattling effect, whereby the propagation of vibration by the host lattice is obstructed by the guest atoms and a small heat conductivity is realized.

This structure has an atomic ratio, in the composition expressed by the above general formula, of a total of 46 host lattice atoms Ga and Ge (Ga+Ge=46) to eight guest atoms Ba. Various compositions combining different types of guest atoms and types of host lattice atoms by the same atomic ratio have been proposed up to now (for example, Japanese Patent Publication (A) No. 2001-44519, Japanese Patent Publication (A) No. 2001-48517, and Japanese Patent Publication (A) No. 2002-274831).

Some of the above proposed clathrate compound thermoelectric materials exhibit superior properties.

For example, the above H. Anno et al. clathrate compounds BagGaₓGe₍₄₆₋ₓ₎ exhibit a performance index ZT of a good value of 1 or so in the case of X=18 at a temperature of 950K (=677°C). However, these require long heat treatment at 800°C for 100 hours to eliminate the segregated phases and therefore had problems in terms of the efficiency and cost of production.

BRYAN J DANIEL ET AL: "Nonstoichiometry and chemical purity effects in thermoelectric Ba8Ga16Ge30 clathrate" JOURNAL OF APPLIED PHYSICS, AMERICAN INSTITUTE OF PHYSICS. NEW YORK, US, vol. 92, no. 12, 15 December 2002 (2002-12-15), pages 7281-7290, XP012056780 ISSN: 0021-8979 discloses a thermoelectric material comprised of a clathrate compound having a composition expressed by the formula Ba₈Ga₁₄Ge₃₁. This document discusses "approximate" stoichiometry of Ba₈Ga₁₄Ge₃₁. There is further a discussion about stability of Ge deficient compositions (page 7288, right hand column, pgh. 3), having a host lattice atomic number of 45. However, this publication does not suggest how to make the claimed host lattice atomic number of 44 and a long heat treatment is required.

### DISCLOSURE OF THE INVENTION

The present invention has as its object the provision of a thermoelectric material comprised of a clathrate compound provided with a superior thermoelectric property equal to that of the above conventional thermoelectric material and not requiring any heat treatment.

To achieve the above object, according to the present invention, there is provided a thermoelectric material comprised of a clathrate compound having a composition expressed by Ba₈GaₓGe₍₄₄₋ₓ₎, where 14≤X≤18. In one embodiment, X is 14. In another embodiment, X is 16. In a further embodiment, X is 18.

The clathrate compound of the present invention, as compared with the atomic ratio of the prior art of 46 host lattice atoms to eight, guest atoms, employs an atomic ratio of a total of 44 atoms of Ga+Ge of the host lattice atoms to eight guest atoms Ba, so is provided with a superior thermoelectric property equal to that of the past while not forming segregated phases and therefore not requiring heat treatment to eliminate the segregated phases like in the past.

### BRIEF DESCRIPTION OF THE DRAWINGS

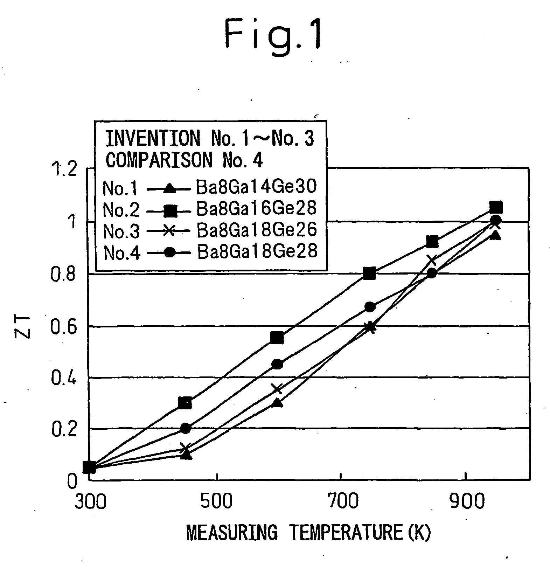

FIG. 1 is a graph showing the relationship between the measurement temperature and performance index ZT in invention examples (Sample Nos. 1 to 3) and a conventional example (Sample No. 4).

### BEST MODE FOR CARRYING OUT THE INVENTION

A thermoelectric material using a clathrate compound is produced by allowing an alloy melt of a predetermined composition to solidify, then crushing the obtained solid alloy to a powder and sintering the same.

In the case of a conventional thermoelectric material, the obtained sintered body had a nonhomogeneous structure with a large number of segregated phases where specific elements concentrated dispersed throughout it. For example, in the case of the conventional typical composition of the above-mentioned Ba₈GaₓGe₍₄₆₋ₓ₎ [X=18], that is, Ba₈Ga₁₈Ge₂₈, concentrated Ba segregated phases were formed. In this state, at least the segregated phases (in a typical example, high Ba) and the parts adjoining the segregated phases (in a typical example, low Ba) deviated from the predetermined composition (in a typical example, to the high Ba side and low Ba side), so the alloy as a whole could not exhibit a good thermoelectric property. To eliminate the segregated phases to obtain a homogeneous structure, long heat treatment at 800°C for 100 hours is required, so this became a big problem in production.

The inventors proceeded with various studies to prevent the formation of segregated phases making long heat treatment necessary. They reached the conclusion, based on the results of differential thermal analysis (DTA), that in a conventional composition BasGaₓGe₍₄₆₋ₓ₎ with 46 host lattice atoms, the liquidus temperature and the solidus temperature are very different, so phase separation easily occurs, while with Ba₈GaₓGe₍₄₄₋ₓ₎ with 44 host lattice atoms, the liquidus temperature and the solidus temperature become remarkably smaller in difference and therefore phase separation substantially does not occur.

Further, the inventors investigated the thermoelectric property of the above Ba₈GaₓGe₍₄₄₋ₓ₎ with 44 host lattice atoms and discovered that a superior performance index ZT equal to the past is obtained.

That is, the thermoelectric material of the present invention does not require the conventional long heat treatment, yet exhibits a superior thermoelectric property equal to the past.

Here, in the conventional thermoelectric material, Ga+Ge=46 and all of the lattice points of the host lattice are buried by Ga or Ge. As opposed to this, in the thermoelectric material of the present invention, Ga+Ge=44, so it is believed that not all of the lattice points of the host lattice are buried and that empty lattice points are included in the structure.

Further, in the thermoelectric material of the present invention, in the composition Ba₈GaₓGe ₍₄₄₋ₓ₎, 14≤X≤18. This is because both when X<14 and when X>18, segregated phases end up occurring and, without heat treatment, a homogeneous structure cannot be obtained.

### EXAMPLES

Clathrate compounds of the compositions shown in Table 1 were produced. Sample Nos. 1, 2, and 3 are compositions of the present invention comprised of Ba₈GaₓGe_{(44-X)} where 14≤x≤18, while Sample No. 4 is an example of a conventional composition of Ba₈GaₓGe₍₄₆₋ₓ₎ where X=18.

As materials, Ba (purity 99.9%), Ga (purity 99.999%), and Ge (purity 99.999%) were weighed out in accordance with the compositions of Table 1 and were arc melted to prepare alloy melts. These were cast into molds and allowed to solidify. The obtained alloy specimens were crushed to powders of a particle size of 75 µm. These were sintered by spark plasma sintering (850°C, 1 hour, pressure 40 MPa) to obtain sintered bodies.

**Table 1**

| Class | Sample no. | Chemical composition | | | |
|---|---|---|---|---|---|
| | | Ba | Ga | Ge | Ga+Ge |
| Invention examples | 1 | 8 | 14 | 30 | 44 |
| | 2 | 8 | 16 | 28 | |
| | 3 | 8 | 18 | 26 | |
| Comparative example | 4 | 8 | 18 | 28 | 46 |

The obtained sintered bodies were examined for structure at a power of 600X by a scan electron microscope. The invention examples (Sample Nos. 1 to 3) were all homogeneous in structure with no segregation observed. The conventional example (Sample No. 4) was nonhomogeneous in structure with a large number of Ba rich segregated phases of several µm to 10 µm or so size distributed throughout it.

Just the conventional example (Sample No. 4) was heat treated at 800°C for 100 hours (in vacuum atmosphere) for annealing. After the heat treatment, the structure was observed in the same way as the above by a scan electron microscope, whereby it was found to be a homogeneous structure with no segregated phases observed.

The thus obtained invention example Sample Nos. 1, 2, and 3 (just sintered for homogeneous structure) and conventional example Sample No. 4 (sintered and annealed for homogeneous structure) were measured for thermoelectric property at various temperatures in the temperature range of 300K (27°C: room temperature) to 950K (677°C). The measurement results are shown as the performance index ZT in FIG. 1.

As shown in FIG. 1, all of the samples, including the invention examples and the conventional example, had a performance index ZT steadily increasing along with the rise in the measurement temperature and had a ZT of substantially 1, that is, had a good thermoelectric property, at the measurement temperature 950K (677°C).

From these results, it is learned that the thermoelectric materials of the invention compositions exhibit a superior thermoelectric property equal to that of the thermoelectric material of the conventional composition without the conventionally indispensible long heat treatment.

Further, among the invention example Sample Nos. 1, 2, and 3, the Sample No. 2 composition Ba₈Ga₁₆Ge₂₈ (where, in Ba₈GaₓGe_{(44-x);} X=16) exhibits a particularly superior thermoelectric property.

### INDUSTRIAL APPLICABILITY

According to the present invention, a thermoelectric material comprised of a clathrate compound not requiring the conventionally indispensible long heat treatment yet provided with a superior thermoelectric property equal to the past is provided.

## Claims

1. A thermoelectric material comprised of a clathrate compound having a composition expressed by the formula:
Ba₈GaₓGe₍₄₄₋ₓ₎
where, 14≤ X ≤18.

2. A thermoelectric material according to claim 1 wherein X is 14.

3. A thermoelectric material according to claim 1 wherein X is 16.

4. A thermoelectric material according to claim 1 wherein X is 18.

## Patentansprüche

1. Thermoelektrisches Material, das aus einer Clathratverbindung besteht, die eine durch die Formel ausgedrückte Zusammensetzung hat:
Ba₈GaₓGe₍₄₄₋ₓ₎,
wobei 14 ≤ X ≤ 18 ist.

2. Thermoelektrisches Material gemäß Anspruch 1, wobei X 14 ist.

3. Thermoelektrisches Material gemäß Anspruch 1, wobei X 16 ist.

4. Thermoelektrisches Material gemäß Anspruch 1, wobei X 18 ist.

## Revendications

1. Matériau thermoélectrique constitué d'un composé de clathrate possédant une composition exprimée par la formulé :
Ba₈GaₓGe₍₄₄₋ₓ₎
où, 14 ≤ X ≤ 18.

2. Matériau thermoélectrique selon la revendication 1, dans lequel X est 14.

3. Matériau thermoélectrique selon la revendication 1, dans lequel X est 16.

4. Matériau thermoélectrique selon la revendication 1, dans lequel X est 18.
